# FASCICULE DE BREVET EUROPEEN

(11) **EP 2 248 404 B1**
(45) Date de publication et mention de la délivrance du brevet: **01.08.2012**
(21) Numéro de dépôt: 09716165.7
(22) Date de dépôt: 08.01.2009
(51) Int. Cl.: H05K 5/06, B65B 55/20, B65D 81/38, B65D 85/38, B65D 81/02, G12B 9/00, E05G 1/00

(54) **PROCÉDÉ DE RÉALISATION D'UNE PROTECTION D'OBJETS ET CAISSON OBTENU PAR SA MISE EN OEUVRE**
VERFAHREN ZUR HERSTELLUNG EINES SCHUTZELEMENTS FÜR GEGENSTÄNDE UND DURCH DIESES VERFAHREN GEWONNENES GEHÄUSE
METHOD FOR MAKING A PROTECTIVE ELEMENT FOR ITEMS AND CASING OBTAINED BY SAID METHOD

(30) Priorité: 08.01.2008 FR 0850091
(43) Date de publication de la demande: 10.11.2010
(73) Titulaire: Faiveley Transport, 93200 Saint Denis (FR)
(72) Inventeur: MARTIN, Arnaud, F-37700 La Ville aux Dames (FR); CHATELAIN, Frédéric, F-37200 Tours (FR)
(74) Mandataire: Novagraaf Technologies
(86) Numéro de dépôt international: PCT/FR2009/000020
(87) Numéro de publication internationale: WO 2009/106761

(56) Documents cités:
- WO-A-2005/025285
- FR-A- 1 509 757
- FR-A- 2 423 618
- FR-A- 2 753 044

## Description

L'invention se rapporte à un procédé de réalisation d'une protection d'objets à l'encontre de conditions environnementales sévères et à un caisson réalisé selon le procédé, en particulier une boîte noire d'enregistrement de données pour l'analyse des causes d'un accident de véhicules, ou un boîtier de conservation longue durée d'objets précieux (voir par exemple le document WO2005/025285A).

La présente invention concerne le domaine de l'isolation thermique au moyen d'un matériau à base de gypse naturel ou synthétique, communément appelé plâtre.

Ce matériau, de formule chimique CaSO₄ 2H₂O, est habituellement utilisé dans le bâtiment. Il possède entre autres qualités la capacité de réaliser une isolation thermique par les réactions endothermiques auxquelles il participe. Il contient en effet environ 20% d'eau sous forme cristalline et jusqu'à 8% d'eau libre résiduelle. Lors de son échauffement, le gypse est le siège d'une première réaction endothermique d'au moins 454 kJ/kg à 1 bar entre 100 et 120°C (vaporisation de 1,5 molécules d'eau auxquelles s'ajoute de l'eau libre résiduelle en proportion variable) puis d'une seconde réaction endothermique de 168kJ/kg à 1 bar entre 200 et 220°C (vaporisation de 0,5 molécule d'eau).

Ainsi, l'utilisation de ce matériau en tant qu'isolant thermique résulte de, la quantité élevée de chaleur absorbée lors des réactions endothermiques, la plus énergétique (la première) se produisant à une température relativement basse (100-120°C). De plus, il ne dégage ni gaz ni vapeur à caractère toxique mais uniquement de l'eau.

Le plâtre est donc plus particulièrement indiqué pour isoler thermiquement des objets.

Un premier procédé connu pour obtenir une isolation thermique consiste à remplir l'espace délimité entre deux parois et, plus particulièrement entre deux volumes imbriqués, d'un ou plusieurs matériaux thermiquement isolants.

Ainsi, dans le document FR2423618, il est décrit une armoire à l'épreuve du feu comprenant un garnissage de plâtre. Ce garnissage est prévu entre un habillage extérieur et un habillage intérieur et est disposé de telle sorte que des températures inadmissibles ne s'établissent pas dans la cavité délimitée par l'habillage intérieur en cas d'incendie.

Toutefois, cette solution présente l'inconvénient de nécessiter deux parois, interne et externe, afin de maintenir l'isolant à base de plâtre. De plus, ce procédé ne permet pas de protéger les objets contre des agressions mécaniques telles que l'écrasement ni de lutter contre une immersion externe.

Par ailleurs, un autre moyen connu pour obtenir une isolation thermique consiste à recouvrir l'objet à protéger d'un matériau à base de plâtre. Un tel procédé est utilisé dans le domaine du bâtiment pour la protection des poutres en acier.

Cependant, ce procédé nécessite l'emploi d'un plâtre spécifique dans le but d'obtenir une bonne tenue mécanique du matériau en cas d'incendie et ainsi éviter qu'il ne se fissure ou ne se détache du support à protéger. De plus, ce procédé n'offre ni une protection mécanique contre les écrasements ni une étanchéité à l'immersion dans des fluides.

Par conséquent, il est utile de rechercher une structure isolante pour maîtriser efficacement un flux thermique et protéger des objets, simple par son procédé de réalisation, à moindres coûts, et qui puisse répondre à des normes strictes de tenue au feu, tout en étant capable d'offrir une protection à l'écrasement et une étanchéité à l'immersion dans des fluides.

La présente invention vise à satisfaire à l'un au moins de ces objectifs à l'aide d'une enveloppe rigide entourant l'objet à protéger recouvert de plâtre. ,

Plus précisément, l'invention a pour objet un procédé de protection d'au moins un objet, consistant à noyer sans emprisonner d'air le ou les objets dans une masse d'isolant à haute résistance thermique à base de cristaux de gypse, de formule brute connue CaSO₄,2H₂O, cette masse d'isolant étant coulée dans une structure à haute résistance mécanique à l'écrasement. Cette structure, n'est pas totalement étanche et réalise l'évacuation de gaz, en particulier de vapeur d'eau, lors de son exposition à des températures élevées. La protection à l'immersion des objets est alors réalisée préalablement, par encapsulage étanche du ou des objets.

Avantageusement, le procédé selon l'invention respecte les normes de tenue au feu et de températures pouvant atteindre environ 1100°C.

De manière avantageuse, le procédé de protection thermique consiste à pondérer la composition de l'isolant par une répartition entre une quantité de cristaux de sulfate de calcium hydraté de type α et une quantité de cristaux de sulfate de calcium hydraté de type β, en fonction de l'épaisseur d'isolant souhaitée et de la température maximale pouvant être supportée par les objets à protéger.

Le sulfate de calcium hémihydrate est à la base de différents plâtres, en particulier les plâtres de type α et β, qui diffèrent par leurs propriétés mécaniques et thermiques. Le plâtre de type α est dense et possède une grande résistance mécanique contrairement au plâtre de type β, plus léger mais plus fragile. La densité élevée du plâtre α permet d'emmagasiner davantage d'eau à l'état cristallin et offre, ainsi, une meilleure protection thermique à volume ou à épaisseur égale.

Selon des caractéristiques particulières, l'isolant à haute résistance thermique est formé majoritairement à base de cristaux de sulfate de calcium de type α et incorpore des liants et/ou des additifs, ainsi qu'une charge minérale inerte. Ces derniers éléments peuvent faciliter le gâchage et modifier le temps de prise du plâtre.

Le taux de gâchage, c'est-à-dire la proportion d'eau ajoutée, est ajusté en fonction de la nature du plâtre et de ses adjuvants pour hydrater complètement le plâtre en laissant le minimum d'eau en excès. Une granulosité faible favorisera son hydratation. Ainsi, le plâtre, une fois sec, possède une porosité faible et la quantité d'eau sous forme cristalline est maximale pour un volume donné.

Selon un mode de réalisation particulier, le procédé consiste à remplir d'une bouillie d'isolant à haute résistance thermique, une enceinte servant de structure à haute résistance mécanique dans laquelle sont placés les objets à protéger, préalablement introduits dans l'enceinte par un orifice (3), puis à obturer l'orifice de remplissage de l'enceinte une fois la bouillie solidifiée.

De manière alternative, un moule temporaire sert de structure, le moule temporaire étant retiré après solidification de la bouillie en un bloc d'isolant à haute résistance thermique, et l'enceinte formée d'au moins deux parties étant disposée à la place du moule pour venir épouser le bloc d'isolant.

Avantageusement, les objets sont placés au centre de l'isolant à haute résistance thermique, de telle sorte que la protection thermique des objets soit isotrope.

L'invention concerne également un caisson réalisé conformément au procédé. Un tel caisson comporte un bloc d'isolant à haute résistance thermique à base de cristaux de gypse, pouvant être majoritairement composé de cristaux de sulfate de calcium hydraté de type α, et une enceinte à haute résistance mécanique à l'écrasement qui épouse la forme externe du bloc d'isolant thermique et une poché étanche à base de silicone encapsulant les objets à protéger, la poche étant disposée de manière sensiblement isotrope au sein de l'isolant à haute résistance thermique. Cette poche étanche permet de les préserver d'une immersion dans tout fluide, en particulier dans l'eau.

Selon des modes de réalisation particuliers :
- le caisson est conformé selon les dimensions d'une boîte noire d'enregistreurs de données, dans laquelle les objets à protéger peuvent être des mémoires de stockage et leurs composants d'interface installés sur une carte électronique. Notamment un convertisseur de signaux ;
- le matériau de l'enceinte est choisi parmi un matériau à base de métal, d'un alliage de métaux, de kevlar et de fibres de carbone :
- l'enceinte comporte au moins une ouverture d'évacuation de vapeur d'eau, en particulier au moins une fente, les molécules d'eau étant libérées à l'état cristallin à partir de l'isolant à haute résistance thermique lorsque celui-ci est soumis à de fortes températures ;
- l'enceinte externe et la poche sont pourvues d'au moins un conduit étanche pour le passage de fils électriques , permettant l'alimentation électrique et l'accès aux mémoires de la carte électronique contenue dans la poche étanche ;
- le caisson est conformé selon les dimensions d'un boîtier de conservation longue durée d'objets précieux à protéger, à l'épreuve des contraintes mécaniques, du feu et des hautes températures.

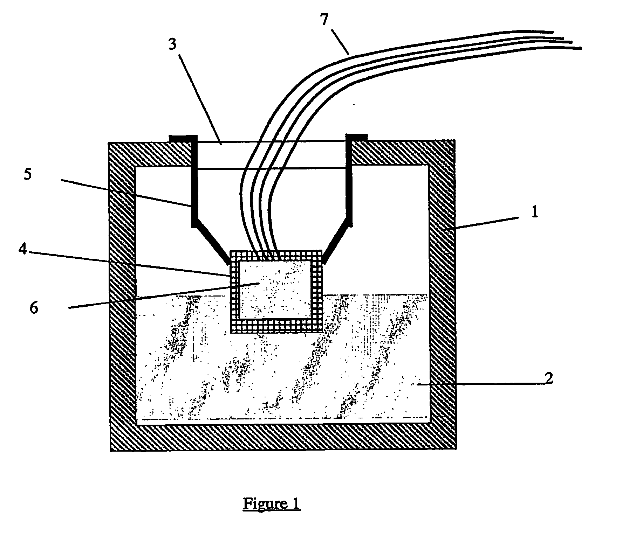

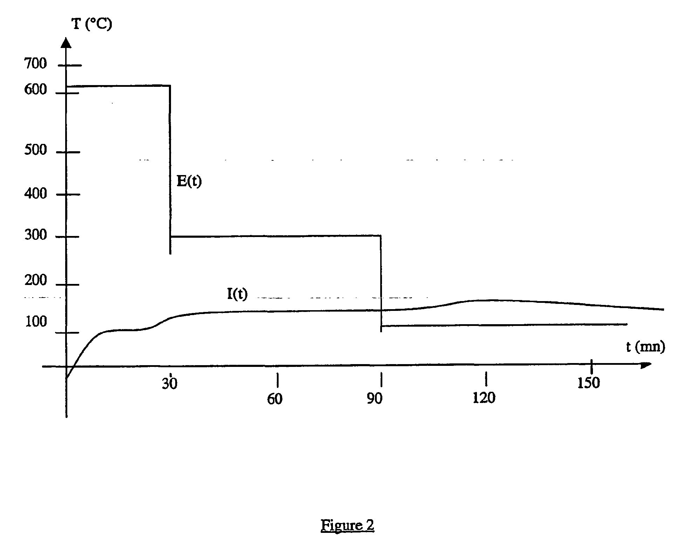

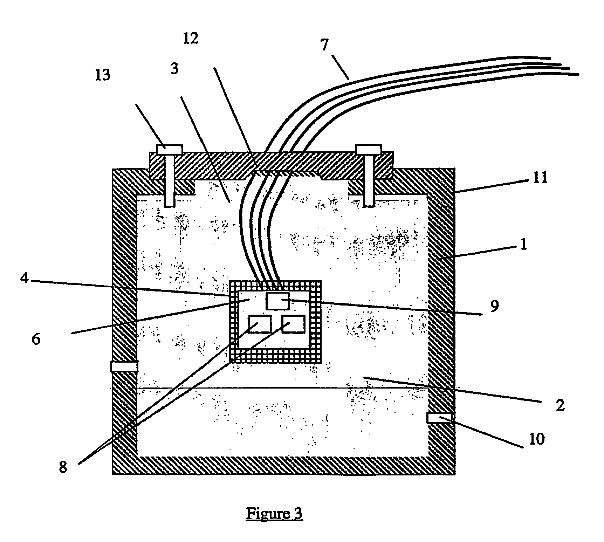

D'autres caractéristiques et avantages de l'invention ressortiront à la lecture qui suit d'un exemple de réalisation détaillé d'une boîte noire d'enregistreur ferroviaire conforme aux exigences de tenue thermique, mécanique et à l'immersion de la norme IEEE 1482.1, en référence aux figures qui représentent respectivement :
- en figure 1, un exemple de mise en oeuvre du procédé de fabrication selon l'invention comportant un encapsulage préalable d'une carte électronique à protéger;
- en figure 2, les courbes d'évolution thermique de l'isolant à haute résistance thermique et de la carte électronique protégée dans la boîte noire obtenue par le procédé selon l'invention, et
- en figure 3, un caisson formant boîte noire réalisé selon le procédé.

La figure 1 illustre un exemple de mise en oeuvre du procédé de l'invention pour la fabrication d'une boîte noire à partir d'une enceinte métallique 1 externe dont le rôle est d'offrir une protection mécanique. Cette enceinte est pourvue d'un orifice 3 par lequel est introduite une poche étanche 4 dans laquelle est encapsulée la carte électronique 6 à protéger thermiquement. Les fils électriques 7 de la carte électronique sortent par cet orifice 3.

Avantageusement, un dispositif de positionnement, telle qu'une pince 5, maintient la poche 4 au centre du moule afin que l'épaisseur d'isolant soit uniforme autour d'elle et par conséquent, que la protection thermique soit isotrope.

L'isolant à base de sulfate de calcium 2 est coulé sous forme de bouillie entre la poche 4 et l'enceinte 1 jusqu'à son remplissage, afin de combler le vide d'air contenu initialement dans l'enceinte 1 et recouvrir la poche 4 ainsi noyée dans la bouillie sans emprisonner d'air. De préférence, cette étape de moulage se fait en deux temps. Dans un premier temps, l'enceinte est remplie jusqu'au niveau du dispositif de maintien 5. Dans un second temps lorsque l'isolant s'est solidifié, le dispositif de maintien 5 est retiré puis, l'enceinte est complétée par l'isolant 2 sous forme de bouillie.

Une fois que l'isolant 2 est solidifié à l'intérieur de l'enceinte 1, l'orifice est comblé par l'ajout d'une plaque fixée sur l'enceinte 1 ou d'un complément métallique intégré dans l'épaisseur de l'enceinte, cette plaque ou ce complément étant découpé pour permettre uniquement le passage des fils électriques 7.

Une variante du procédé décrit précédemment consiste à utiliser un moule temporaire au lieu de l'enceinte métallique 1 lors des opérations de moulage. Une fois l'isolant solidifié, le moule est retiré et l'enceinte métallique formée par exemple de deux demi-coques est ajoutée.

La figure 2 représente la courbe d'évolution thermique E(t) d'un isolant à haute résistance thermique à base de cristaux de sulfate de calcium hémihydrate, utilisé dans le procédé décrit ci-dessus. Pour une meilleure compacité de la boîte noire, l'isolant retenu a été préparé à partir d'un plâtre composé majoritairement à base de cristaux de sulfate de calcium hémihydrate de type α. La figure 2 illustre également la courbe de température I(t) de la carte électronique ainsi protégée. La boîte noire ainsi réalisée a été soumise à un essai de tenue thermique selon la norme IEEE 1482.1.

La courbe d'évolution de température E(t) donne la température ambiante à laquelle la boîte noire est exposée. La courbe I(t) donne la température relevée au niveau de la carte électronique située au coeur de la boîte noire. Cette dernière montre le maintien à température raisonnable de la carte électronique, qui ne dépasse pas des températures de l'ordre de 180°C - alors que la température ambiante E(t) a atteint 650°C - permettant ainsi de conserver les données enregistrées dans des mémoires de type FLASH.

Conformément à la figure 3, un caisson 11 de type boîte noire réalisé selon le procédé décrit précédemment, est disposé dans un emplacement sécurisé de la locomotive d'un train. Il est pourvu d'une enceinte métallique externe 1, d'une couche d'isolant à haute résistance thermique 2 coulée entre l'enceinte 1 et la poche 4 en silicone. La poche 4 encapsule des mémoires de stockage de données 8 sur une carte électronique 6 associée à un convertisseur de signaux 9 vers un enregistreur de données disposé hors du caisson par le biais de câbles électriques 7.

La boîte noire 11 est pourvue d'orifices 10 de part et d'autre de l'enveloppe externe 1, permettant d'évacuer la vapeur d'eau provenant de l'isolant 2, lorsque celui-ci est soumis à de fortes températures, et de maintenir une pression acceptable au sein du caisson 11. Ainsi, la température des objets 8, 9, et 6 à protéger n'augmente pas par le biais de ce phénomène.

Par ailleurs, l'orifice 3 est fermé par l'ajout d'une plaque métallique 12 fixée par des vis 13 sur l'enceinte 1. La plaque métallique 12 est préparée, par exemple par perçage calibré d'un ou de plusieurs conduits étanches, de manière à permettre le passage uniquement des fils électriques 7 entre cette plaque et l'enceinte 1, ce qui n'altère en rien la protection thermo-mécanique des mémoires de stockage 8 et du convertisseur de signaux 9.

Dans cet exemple, l'enveloppe externe 1 est à base d'acier et présente une épaisseur suffisante, d'environ 5 millimètres, pour constituer une protection mécanique. Les dimensions externes de la boîte noire 11 sont de 17x8x11 cm³. Dans d'autres exemples, cette épaisseur peut varier en fonction des normes de résistance mécanique applicables.

Le matériau à base de silicone de la poche 4 permet avantageusement d'assurer l'étanchéité du contenu de la poche en cas d'immersion dans l'eau de la boîte noire 11 ou en regard de l'eau s'évaporant de l'isolant 2 lors des phases de réactions endothermiques. De plus des ouvertures étanches (non représentées) sont prévues dans la poche 4 pour le passage des fils électriques 7.

Compte tenu de ce qui précède, l'isolant à haute résistance thermique 2 permet aux éléments 8, 9 et 6, devant être protégé, et plus particulièrement à la mémoire de stockage 8, de ne pas dépasser des températures supérieures à 150°C. Par ailleurs, la boîte noire 11 peut résister à des températures extérieures supérieures à 750°C, par exemple de l'ordre de 900°C à 1000°C ou 1100°C par augmentation de ses dimensions.

Alternativement, le caisson de protection forme une enceinte de conservation longue durée permettant de préserver à l'abri du feu, des contraintes mécaniques et des températures sévères, l'intégrité d'objets précieux pour l'utilisateur. Les dimensions de l'enceinte de conservation sont avantageusement comprises entre 5x5x5 cm³ et 100x50x50 cm³. Ainsi, le volume et le poids de l'enceinte selon l'invention présentent à l'égard de l'utilisateur une grande commodité de transport et de stockage. Ce caisson de protection longue durée peut avantageusement comporter des moyens d'ouverture/fermeture ménagés dans l'enveloppe, par exemple par charnière et verrou de sécurité, de manière à pouvoir accéder aisément aux objets et éventuellement les remplacer.

L'invention n'est pas limitée aux exemples de réalisations décrits et représentés ci-dessus. En effet, la forme de l'enceinte externe 1 et de l'isolant à haute résistance thermique 2, représentée ci-dessus sous forme parallélépipédique, peut tout aussi bien être cylindrique ou de révolution.

En outre, le procédé peut être mis en oeuvre en formant une cavité dans la masse d'isolant à haute résistance thermique, en introduisant une bouillie d'isolant à haute résistance thermique contenant les objets à protéger thermiquement, à combler la cavité par la bouillie et à laisser sécher jusqu'à solidification de la bouillie de manière à uniformiser l'ensemble bouillie et masse. Avantageusement, la cavité est conformée de manière à centrer dans la masse les objets à protéger.

L'enceinte externe 1 peut être constituée d'un autre matériau hautement résistant mécaniquement, tel que le kevlar ou le carbone. L'épaisseur de l'isolant à haute résistance thermique 2 peut être sensiblement plus élevé que 5 mm comme décrit ci-dessus, afin de protéger un élément contre des températures encore plus élevées, au vu de normes de tenue au feu plus strictes, comme celles relatives aux aéronefs.

Par ailleurs, le caisson de protection ne se limite pas à une boîte noire ou une enceinte de conservation, mais peut tout aussi bien être utilisé pour la protection thermique de tout type de caisson, tel qu'une caisse de transport de biens, d'aliments ou de médicaments ou encore une caisse de transport de munitions.

## Revendications

1. Procédé de protection d'au moins un objet, **caractérisé en ce qu'**il consiste à noyer, sans emprisonner d'air, le ou les objets (6, 8, 9) dans une masse d'isolant à haute résistance thermique (2) à base de cristaux de gypse, cette masse d'isolant (2) étant coulée dans une structure (1) à haute résistance mécanique à l'écrasement, et à réaliser préalablement une protection à l'immersion des objets par encapsulage étanche du ou des objets à protéger.

2. Procédé de protection selon la revendication 1, dans lequel la structure (1) opère une évacuation de gaz lors de son exposition à des températures élevées.

3. Procédé de protection selon l'une quelconque des revendications précédentes, **caractérisé en ce qu'**il consiste à pondérer la composition de l'isolant (2) par une répartition entre une quantité de cristaux de sulfate de calcium hydraté de type α et une quantité de cristaux de sulfate de calcium hydraté de type β, en fonction de l'épaisseur dudit isolant (2) souhaitée et de la température maximale pouvant être supportée par les objets à protéger (6, 8, 9).

4. Procédé de protection selon la revendication précédente, **caractérisé en ce que** l'isolant à haute résistance thermique (2) est majoritairement composé de cristaux de sulfate de calcium hydraté de type α.

5. Procédé de protection selon l'une quelconque des revendications précédentes, **caractérisé en ce que** l'isolant à haute résistance thermique (2) contient en outre des liants et/ou des additifs.

6. Procédé de protection selon l'une quelconque des revendications précédentes, **caractérisé en ce que** l'isolant à haute résistance thermique (2) incorpore en outre une charge minérale inerte.

7. Procédé de protection selon l'une quelconque des revendications précédentes, **caractérisé en ce qu'**il consiste à remplir, à l'aide d'une bouillie d'isolant (2) à haute résistance thermique, une enceinte (1) servant de structure à haute résistance mécanique dans laquelle sont placés les objets (6, 8, 9) à protéger, préalablement encapsulés dans une poche étanche (|4|) et introduits dans l'enceinte par un orifice (3), puis à obturer l'orifice de remplissage de l'enceinte une fois la bouillie solidifiée.

8. Procédé de protection selon l'une quelconque des revendications 1 à 6, **caractérisé en ce qu'**il consiste à remplir, à l'aide d'une bouillie d'isolant (2) à haute résistance thermique, un moule temporaire servant de structure et dans lequel sont placés les objets (6, 8, 9) à protéger préalablement encapsulés dans une poche étanche (4), puis à retirer le moule temporaire après solidification de la bouillie en un bloc d'isolant à haute résistance thermique, et à disposer une enceinte (1) formée d'au moins deux parties à la place du moule pour venir épouser le bloc d'isolant.

9. Procédé de protection selon l'une quelconque des revendications précédentes, dans lequel les objets à protéger sont placés sensiblement au centre de l'isolant à haute résistance thermique, de telle sorte que la protection thermique des objets soit isotrope.

10. Caisson de protection obtenu par le procédé selon l'une quelconque des revendications précédentes, **caractérisé en ce qu'**il comporte un bloc d'isolant à haute résistance thermique (2) à base de cristaux de gypse, majoritairement composé de cristaux de sulfate de calcium hydraté de type α, une enceinte (1) à haute résistance mécanique à l'écrasement qui épouse la forme externe du bloc d'isolant thermique (2), et une poché étanche (4) à base de silicone encapsulant les objets à protéger, la poche étant disposée de manière sensiblement isotrope au sein de l'isolant à haute résistance thermique.

11. Caisson de protection selon la revendication précédente, dans lequel le matériau de l'enceinte est choisi parmi un matériau à base de métal, de kevlar et de fibres de carbone.

12. Caisson de protection selon l'une quelconque des revendications 10 à 11, dans lequel l'enceinte comporte des ouvertures (10) d'évacuation de vapeur d'eau.

13. Caisson de protection selon l'une quelconque des revendications 10 à 12, **caractérisé en ce qu'**il est conformé selon les dimensions d'une boîte noire d'enregistreurs de données (11).

14. Caisson formant boîte noire selon la revendication précédente, **caractérisé en ce que** lesdits objets à protéger (6, 8, 9) sont une mémoire de stockage (8) et un convertisseur de signaux (9) installés sur une carte électronique.

15. Caisson formant boîte noire selon la revendication précédente, **caractérisé en ce que** l'enceinte externe (1) et la poche (4) sont pourvues d'au moins un conduit étanche pour le passage de fils électriques (7).

16. Caisson de protection selon l'une quelconque des revendications 10 à 12, **caractérisé en ce qu'**il est conformé selon les dimensions d'un boîtier de conservation longue durée d'objets précieux à protéger.

## Claims

1. Method for protecting at least one object, **characterised in that** it comprises embedding the objects (6, 8, 9), without trapping any air, in an insulating mass of high thermal resistance (2) based on gypsum crystals, the said insulating mass (2) being cast in a structure (1) having a high mechanical resistance to crushing, and providing in advance protection of the objects against immersion by watertight encapsulation of the object or objects to be protected.

2. Protection method according to claim 1, wherein the structure (1) effects a discharge of gases when it is exposed to high temperatures.

3. Protection method according to any one of the preceding claims, **characterised in that** it comprises weighting the composition of the insulator (2) by a distribution between a quantity of crystals of hydrated calcium sulphate of type α and a quantity of crystals of hydrated calcium sulphate of type β, in relation to the desired thickness of the said insulator (2) and the maximum temperature that the objects to be protected (6, 8, 9) are able to withstand.

4. Protection method according to the preceding claim, **characterised in that** the high thermal resistance insulator (2) is mainly composed of crystals of hydrated calcium sulphate of type α.

5. Protection method according to any one of the preceding claims, **characterised in that** the high thermal resistance insulator (2) additionally contains binders and/or additives.

6. Protection method according to any one of the preceding claims, **characterised in that** the high thermal resistance insulator (2) additionally incorporates an inert mineral filler.

7. Protection method according to any one of the preceding claims, **characterised in that** it comprises filling, with a slurry of high thermal resistance insulator (2), an enclosure (1) serving as a structure of high mechanical strength in which are placed the objects (6, 8, 9) to be protected, previously encapsulated in a sealed pocket (4) and introduced into the enclosure through an orifice (3), then closing off the filling orifice of the enclosure once the slurry has solidified.

8. Protection method according to any one of claims 1 to 6, **characterised in that** it comprises filling, with a slurry of high thermal resistance insulator (2), a temporary mould serving as a structure and in which are placed the objects (6, 8, 9) to be protected previously encapsulated in a sealed pocket (4), then removing the temporary mould after the slurry has solidified into a high thermal resistance insulating block, and disposing an enclosure (1) formed by at least two parts in place of the mould so as to conform to the shape of the insulating block.

9. Protection method according to any one of the preceding claims, wherein the objects to be protected are placed substantially at the centre of the high thermal resistance insulator so that the thermal protection of the objects is isotropic.

10. Protective casing obtained by the method according to any one of the preceding claims, **characterised in that** it comprises a block of high thermal resistance insulation (2) based on gypsum crystals, mainly composed of crystals of hydrated calcium sulphate of type α, an enclosure (1) of high mechanical resistance to crushing which conforms to the external shape of the block of thermal insulation (2), and a silicone-based sealed pocket (4) encapsulating the objects to be protected, the pocket being disposed substantially isotropically within the high thermal resistance insulation.

11. Protective casing according to the preceding claim, wherein the material of the enclosure is chosen from a material based on metal, kevlar and carbon fibres.

12. Protective casing according to any one of claims 10 to 11, wherein the enclosure includes openings (10) for the removal of water vapour.

13. Protective casing according to any one of claims 10 to 12, **characterised in that** it is conformed according to the dimensions of a black box data recorder (11).

14. Casing forming a black box according to the preceding claim, **characterised in that** the said objects to be protected (6, 8, 9) are a storage memory (8) and a signal converter (9) mounted on an electronic board.

15. Casing forming a black box according to the preceding claim, **characterised in that** the external enclosure (1) and the pocket (4) are provided with at least one sealed conduit for the passage of electric wires (7).

16. Protective casing according to any one of claims 10 to 12, **characterised in that** it is conformed according to the dimensions of a housing for long-term storage of valuable objects to be protected.

## Patentansprüche

1. Verfahren zum Schutz mindestens eines Gegenstandes, dadurch gekennzeichn e t , dass es darin besteht, den oder die Gegenstände (6, 8, 9) ohne Lufteinschluss in eine Isolatormasse (2) von hoher Temperaturbeständigkeit auf Basis von Gipskristallen einzugießen, wobei die Isolatormasse (2) in eine Struktur (1) von hoher mechanischer Widerstandskraft gegen Zerdrücken gegossen wird, und des weiteren darin, zuvor einen Schutz der Gegenstände gegenüber dem Eintauchen durch flüssigkeitsdichte Einkapselung des oder der Gegenstände zu realisieren.

2. Schutzverfahren nach Anspruch 1, wobei die Struktur (1), wenn sie hohen Temperaturen ausgesetzt ist, eine Gasabfuhr durchführt.

3. Schutzverfahren nach einem der vorstehenden Ansprüche, **dadurch gekennzeichnet , dass** es darin besteht, die Zusammensetzung des Isolators (2) durch eine Aufteilung zwischen einer Menge an hydrierten Kalziumsulfatkristallen vom Typ α und einer Menge an hydrierten Kalziumsulfatkristallen vom Typ β in Abhängigkeit von der gewünschten Dicke des Isolators (2) und der maximalen Temperatur abzustimmen, der die zu schützenden Gegenstände (6, 8, 9) standhalten können.

4. Schutzverfahren nach dem vorstehenden Anspruch, **dadurch gekennzeichnet, dass** der Isolator (2) von hoher Temperaturbeständigkeit zum größeren Teil aus hydrierten Kalziumsulfatkristallen vom Typ α zusammengesetzt ist.

5. Schutzverfahren nach einem der vorstehenden Ansprüche, **dadurch gekennzeichnet, dass** der Isolator (2) von hoher Temperaturbeständigkeit unter anderem Bindemittel und/oder Zusätze enthält.

6. Schutzverfahren nach einem der vorstehenden Ansprüche, **dadurch gekennzeichnet, dass** der Isolator (2) von hoher Temperaturbeständigkeit unter anderem einen inerten mineralischen Füllstoff beinhaltet.

7. Schutzverfahren nach einem der vorstehenden Ansprüche, **dadurch gekennzeichnet, dass** es darin besteht, eine Ummantelung (1), die als Struktur von hoher mechanischer Widerstandskraft gegen Zerdrücken dient und in der die zu schützenden Gegenstände (6, 8, 9) angeordnet sind, mittels eines Isolatorbreis (2) von hoher Temperaturbeständigkeit zu füllen, wobei die Gegenstände zuvor in eine flüssigkeitsdichte Kapsel (4) eingekapselt und in die Ummantelung über eine Öffnung (3) eingeführt werden, und anschließend die Befüllungsöffnung der Ummantelung zu verschließen, sobald der Brei erstarrt ist.

8. Schutzverfahren nach einem der Ansprüche 1 bis 6, **dadurch gekennzeichnet, dass** es darin besteht, eine vorübergehende Form, die als Struktur dient und in der die zu schützenden Gegenstände (6, 8, 9) angeordnet sind, mittels eines Isolatorbreis (2) von hoher Temperaturbeständigkeit zu füllen, wobei die Gegenstände zuvor in eine flüssigkeitsdichte Kapsel (4) eingekapselt wurden, dann die temporäre Form zu entfernen, nachdem sich der Brei zu einem Isolatorblock von hoher Temperaturbeständigkeit verfestigt hat, und eine Ummantelung (1), die aus mindestens zwei Teilen gebildet ist, an Stelle der Form anzuordnen, um sie an den Isolatorblock anzupassen.

9. Schutzverfahren nach einem der vorstehenden Ansprüche, bei dem die zu schützenden Gegenstände im wesentlichen in der Mitte des Isolators von hoher Temperaturbeständigkeit angeordnet sind, sodass der thermische Schutz der Gegenstände isotrop ist.

10. Durch das Verfahren nach einem der vorstehenden Ansprüche erlangter Schutzkasten, **dadurch gekennzeichnet, dass** er einen Isolatorblock (2) von hoher Temperaturbeständigkeit auf Basis von Gipskristallen, welcher zum größeren Teil aus hydrierten Kalziumsulfatkristallen vom Typ α zusammengesetzt ist, sowie eine Ummantelung (1) von hoher mechanischer Widerstandskraft gegen Zerdrücken, die an die äußere Form des thermischen Isolatorblocks (2) angepasst ist, und eine flüssigkeitsdichte Kapsel (4) umfasst, welche die zu schützenden Gegenstände einschließt, wobei die Kapsel im wesentlichen isotrop inmitten des Isolators von hoher Temperaturbeständigkeit angeordnet ist.

11. Schutzkasten nach dem vorstehenden Anspruch, bei dem das Material der Ummantelung aus einem Material auf Basis von Metall, von Kevlar und von Kohlenstofffasern ausgewählt ist.

12. Schutzkasten nach einem der Ansprüche 10 bis 11, bei dem die Ummantelung Öffnungen (10) zur Abfuhr von Wasserdampf aufweist.

13. Schutzkasten nach einem der Ansprüche 10 bis 12, **dadurch gekennzeichnet, dass** er an die Abmessungen einer Datenschreiber-Blackbox (11) angepasst ist.

14. Schutzkasten, der eine Blackbox bildet nach dem vorstehenden Anspruch, dadurch g e - **kennzeichnet**, dass die zu schützenden Gegenstände (6, 8, 9) ein Datenspeicher (8) und ein Signalumwandler (9) sind, welche auf einer elektronischen Platine installiert sind.

15. Schutzkasten, der eine Blackbox bildet nach dem vorstehenden Anspruch, **dadurch gekennzeichnet, dass** die äußere Ummantelung (1) und die Kapsel (4) mit mindestens einer flüssigkeitsdichten Leitung zum Aufnehmen elektrischer Drähte (7) versehen sind.

16. Schutzkasten nach einem der Ansprüche 10 bis 12, **dadurch gekennzeichnet, dass** er an die Abmessungen eines Gehäuses zur langfristigen Aufbewahrung von wertvollen, zu schützenden Gegenständen angepasst ist.
